# EUROPEAN PATENT APPLICATION

(11) **EP 4 678 785 A1**
(43) Date of publication of application: **14.01.2026**
(21) Application number: 24766755.3
(22) Date of filing: 08.02.2024
(51) Int. Cl.: C23C 16/455, C23C 16/40, H01L 21/365, H01L 21/368

(54) **FILM FORMATION NOZZLE AND FILM FORMATION DEVICE**

(30) Priority: 07.03.2023 JP 2023034658
(71) Applicant: SHIN-ETSU CHEMICAL CO., LTD., Tokyo 1000005 (JP)
(72) Inventor: HASHIGAMI, Hiroshi, Annaka-shi, Gunma 379-0195 (JP); WATABE, Takenori, Annaka-shi, Gunma 379-0195 (JP)
(74) Representative: Schicker, Silvia
(86) International application number: PCT/JP2024/004274
(87) International publication number: WO 2024/185380

(57) **Abstract**

The present invention is a film-forming nozzle wherein: the film-forming nozzle supplies a gas mixture to a substrate surface, the gas mixture including a carrier gas and a raw material mist obtained by atomizing a liquid raw material; and includes a supply port into which the gas mixture flows, and a discharge port spatially connected to the supply port and from which the gas mixture flows out; and an inner surface of a flow path of the gas mixture from the supply port to the discharge port of the film-forming nozzle is covered with a coating made of a material different from a base material forming a basic structure of the film-forming nozzle. This provides a film-forming nozzle and a film-forming apparatus that can stably produce high-quality films with significantly reduced impurity contamination, foreign matter (particle) adhesion, and abnormal growth.

## Description

### TECHNICAL FIELD

The present invention relates to a film-forming nozzle and a film-forming apparatus that supply atomized liquid raw material to a substrate to conduct film-forming.

### BACKGROUND ART

As a method capable of forming epitaxial films, etc. at low temperatures and at atmospheric pressure, film-forming means using fine water particles such as mist CVD method are known. In addition, particularly for the large diameter boards, a method for supplying mist from a mist discharge nozzle is being considered.

Patent Document 1 shows a film-forming apparatus in which film-forming is conducted during the process in which the mist is sprayed vertically from a nozzle flows in horizontal direction between the nozzle bottom and the substrate surface. In addition, Patent Document 2 shows a film-forming apparatus in which film-forming is conducted by supplying a raw material mist to a substrate from a nozzle placed at an angle to the substrate.

### CITATION LIST

### PATENT LITERATURE

Patent Document 1: WO2016051559A1
Patent Document 2: JP2018-142637A

### SUMMARY OF INVENTION

### TECHNICAL PROBLEM

However, in conventional film-forming apparatus, there was a problem that the components of the nozzle would dissolve into the raw material mist and incorporated into the film as impurities, and degrades the quality of the film. In addition, if the nozzle is heated by a heat source that heats a base substrate (board), the evaporation of the raw material mist progresses inside the nozzle, causing the droplets to concentrate. Also, change in acidity, etc. can cause the ligands of precursor to change, denaturing the droplet into a form unsuitable for film-forming. These concentrated or denatured mists do not contribute to the desired film-forming but form precipitates that adhere to the film, or form nuclei on the film and cause abnormal growth to occur, becoming problems to the stable manufacturing of high-quality films.

The present invention has been made in view of above problems. An object of the present invention is to provide a film-forming nozzle and a film-forming apparatus that are capable of stably manufacturing high-quality films with significantly reduced impurity contamination, foreign matter (particle) adhesion, and abnormal growth.

### SOLUTION TO PROBLEM

In order to achieve the object, the present invention provides a film-forming nozzle, wherein:
the film-forming nozzle supplies a gas mixture to a substrate surface, the gas mixture comprising a carrier gas and a raw material mist obtained by atomizing a liquid raw material; and
comprises a supply port into which the gas mixture flows, and a discharge port spatially connected to the supply port and from which the gas mixture flows out; and
an inner surface of a flow path of the gas mixture from the supply port to the discharge port of the film-forming nozzle is covered with a coating made of a material different from a base material forming a basic structure of the film-forming nozzle.

With such a film-forming nozzle, the coating can prevent contact between the gas mixture and the inner surface of the base material of the film-forming nozzle, and prevent the components of the base material from eluting into the raw material mist. This suppresses the contamination of impurities in the film formed on the substrate surface, and allows the formation of a high-quality film.

In this case, the film-forming nozzle is preferably equipped with a temperature adjustment part for adjusting a temperature of the film-forming nozzle.

With such film-forming nozzle, the temperature of the film-forming nozzle can be adjusted using the temperature adjustment part, preventing damage to the coating due to heat and reducing the generation of particles due to the evaporation of the raw material mist in the previous stages of film-forming, making it possible to form films with fewer defects under a wider variety of conditions.

In this case, the film-forming nozzle is preferably covered with the coating on an outer surface of the film-forming nozzle, the outer surface being at least a surface that faces a film-forming surface of a substrate on which a film is to be formed.

With such a film-forming nozzle, the coating can prevent contact between the gas mixture and the outer surface of the base material (the surface facing film-forming surface of the substrate) of the film-forming nozzle, and prevent the components of the outer surface of the base material from eluting into the raw material mist, making it possible to form high-quality films with reduced impurity contamination to the film in a wider variety of film-forming configurations.

In this case, the coating preferably comprises at least one of a polyethylene, a polypropylene, a vinyl chloride, a polystyrene, a polyvinyl acetate, an urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.

With such a film-forming nozzle makes it possible to form high-quality films with reduced impurity contamination to the film more effectively.

In this case, at least a part of a surface of the coating is preferably water repellent.

With such a film-forming nozzle, droplet adhesion to the inner surface of the film-forming nozzle is reduced, suppressing the occurrence of particles generated by precipitation of solids in the droplets and denaturation of the droplets and compounds causing defects, making it possible to more stably form high-quality films.

In this case, a thermal conductivity of the coating is preferably lower than a thermal conductivity of the base material.

With such a film-forming nozzle, the coating does not conduct heat as much as the base material, so the temperature of the gas mixture can be kept even when the gas mixture comes into contact with the coating, suppressing the evaporation of the mist and suppressing abnormal growth of the film and the precipitation (particle) adhesion to the film caused by the concentration or denaturation of the mist, making it possible to more stably form higher-quality films.

In this case, the base material preferably contains at least one of a metal, a glass, and a ceramic.

With such a film-forming nozzle, temperature adjustment of the film-forming nozzle becomes easy, making it easier to form high-quality films.

The present invention also provides a film-forming apparatus, wherein the film-forming apparatus comprises:
an atomization means for atomizing a liquid raw material to generate a raw material mist; a carrier gas for transporting the raw material mist; a film-forming nozzle for supplying a gas mixture to a substrate surface, the gas mixture being a mixture of the raw material mist and the carrier gas; an exhaust means for exhausting the gas mixture; a mounting part for mounting the substrate; a heating means for heating the substrate; and wherein:
the film-forming nozzle comprises a supply port into which the gas mixture flows, and a discharge port spatially connected to the supply port and from which the gas mixture flows out; and
an inner surface of a flow path of the gas mixture from the supply port to the discharge port of the film-forming nozzle is covered with a coating made of a material different from a base material forming a basic structure of the film-forming nozzle.

With such a film-forming apparatus, the coating can prevent contact between the gas mixture and the inner surface of the base material in the film-forming nozzle, and prevent the components of the base material from eluting into the raw material mist, making it possible to form high-quality films with suppressed impurity contamination to the film formed on the substrate surface.

In this case, the film-forming nozzle preferably comprises a temperature adjustment part for adjusting a temperature of the film-forming nozzle.

With such a film-forming apparatus, the temperature of the film-forming nozzle can be adjusted using the temperature adjustment part, preventing damage to the coating due to heat and reducing the generation of particles due to the evaporation of the raw material mist in the previous stages of film-forming, making it possible to form films with fewer defects under a wider variety of conditions.

In this case, the film-forming nozzle is preferably covered with the coating on an outer surface of the film-forming nozzle, the outer surface being at least a surface that faces a film-forming surface of a substrate on which a film is to be formed.

With such a film-forming apparatus, the coating can prevent contact between the gas mixture and the outer surface of the base material (the surface facing film-forming surface of the substrate) of the film-forming nozzle, and prevent the components of the outer surface of the base material from eluting into the raw material mist, making it possible to form high-quality films with reduced impurity contamination to the film in a wider variety of film forming configurations.

In this case, the coating preferably comprises at least one of a polyethylene, a polypropylene, a vinyl chloride, a polystyrene, a polyvinyl acetate, an urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.

With such a film-forming apparatus makes it possible to form high-quality films with reduced impurity contamination to the film more effectively.

In this case, at least a part of a surface of the coating is preferably water repellent.

With such a film-forming apparatus, droplet adhesion to the inner surface of the film-forming nozzle is reduced, suppressing the occurrence of particles generated by precipitation of solids in the droplets and denaturation of the droplets and compounds causing defects, making it possible to more stably form high-quality films.

In this case, thermal conductivity of the coating is preferably lower than a thermal conductivity of the base material.

With such a film-forming apparatus, the coating does not conduct heat as much as the base material, so the temperature of the gas mixture can be kept even when the gas mixture comes into contact with the coating, suppressing the evaporation of the mist and suppressing abnormal growth of the film and the precipitation (particle) adhesion to the film caused by the concentration or denaturation of the mist, making it possible to more stably form higher-quality films.

In this case, the base material preferably contains at least one of a metal, a glass, and a ceramic.

With such a film-forming apparatus, temperature adjustment of the film-forming nozzle becomes easy, making it easier to form high-quality films.

### ADVANTAGEOUS EFFECTS OF INVENTION

According to the present invention, it is possible to provide a film-forming nozzle and a film-forming apparatus that can stably produce high-quality films with significantly reduced impurity contamination, foreign matter (particle) adhesion, and abnormal growth.

### BRIEF DESCRIPTION OF DRAWINGS

[FIG. 1] is a figure showing a configuration of a film-forming nozzle pertaining to the present invention.
[FIG. 2] is a figure showing a configuration in which the film-forming nozzle pertaining to the present invention is used at an angle.
[FIG. 3] is a figure showing a different configuration of the film-forming nozzle pertaining to the present invention.
[FIG. 4] is a figure showing a configuration of a film-forming apparatus pertaining to the present invention.

### DESCRIPTION OF EMBODIMENTS

As described above, there has been a demand for providing a film-forming nozzle and a film-forming apparatus that can stably manufacture high-quality films with significantly reduced impurity contamination, foreign matter (particle) adhesion, and abnormal growth.

The present inventors have studied earnestly on the problems and found out that high-quality films can be stably manufactured by covering an inner surface of a flow path of the gas mixture from the supply port to the discharge port of the film-forming nozzle is covered with a coating made of a material different from a base material forming a basic structure of the film-forming nozzle. Thus, the present invention has been completed.

That is, the present invention is a film-forming nozzle, wherein:
the film-forming nozzle supplies a gas mixture to a substrate surface, the gas mixture comprising a carrier gas and a raw material mist obtained by atomizing a liquid raw material; and
comprises a supply port into which the gas mixture flows, and a discharge port spatially connected to the supply port and from which the gas mixture flows out; and
an inner surface of a flow path of the gas mixture from the supply port to the discharge port of the film-forming nozzle is covered with a coating made of a material different from a base material forming a basic structure of the film-forming nozzle.

The present invention also provides a film-forming apparatus, wherein the film-forming apparatus comprises:
an atomization means for atomizing a liquid raw material to generate a raw material mist;
a carrier gas for transporting the raw material mist;
a film-forming nozzle for supplying a gas mixture to a substrate surface, the gas mixture being a mixture of the raw material mist and the carrier gas;
an exhaust means for exhausting the gas mixture; a mounting part for mounting the substrate; a heating means for heating the substrate; and wherein:
   the film-forming nozzle comprises a supply port into which the gas mixture flows, and a discharge port spatially connected to the supply port and from which the gas mixture flows out; and
   an inner surface of a flow path of the gas mixture from the supply port to the discharge port of the film-forming nozzle is covered with a coating made of a material different from a base material forming a basic structure of the film-forming nozzle.

The film-forming nozzle and the film-forming apparatus of the present invention will be described in detail below. However, the present invention is not limited thereto.

### [Film-forming Nozzle]

The present invention provides a film-forming nozzle that can supply a raw material mist suitable for good film-forming to a substrate without impairing the quality of the raw material mist.

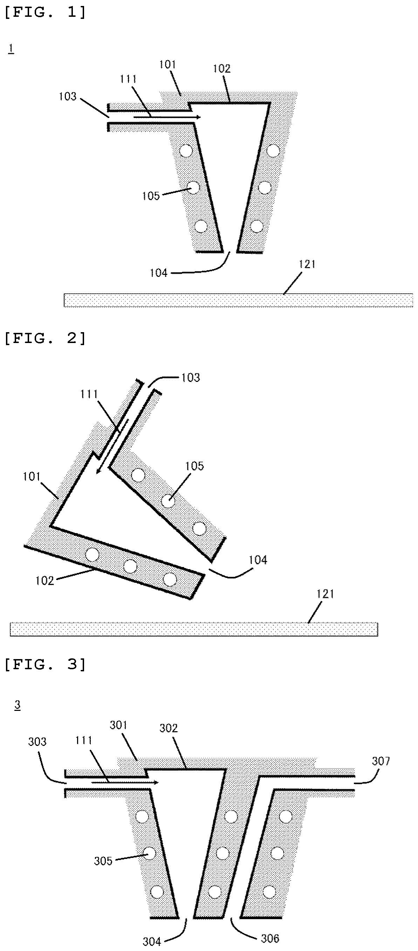

The present invention will be described in detail below with reference to FIGs. 1, 2 and 3.

FIG. 1 shows an example of a film-forming nozzle pertaining to the present invention.

The film-forming nozzle 1 pertaining to the present invention is equipped with the supply port 103, the discharge port 104, and the temperature adjustment part 105, and comprises the base material 101 and the coating 102 that covers the inner surface of the base material 101. The gas mixture 111 of raw material mist and carrier gas is supplied to the supply port 103, and is discharged from the discharge port 104 onto the board 121, which is a typical substrate.

With such a film-forming nozzle 1, the coating 102 can prevent contact between the gas mixture 111 and the inner surface of the base material 101 of the film-forming nozzle 1, and can prevent the components of the base material 101 from dissolving into the raw material mist, thereby suppressing the impurity contamination to the film formed on the surface of board (base material) 121, and allows the formation of a high-quality film.

The setting position of the supply port 103 in the film-forming nozzle 1 is not particularly limited, and it may be different from the discharge direction of the gas mixture 111 or may be set in a straight line. In addition, a plurality of supply ports can be set. The shape of the discharge port 104 may be designed as necessary according to the shape of the substrate (board) on which the film is to be formed and the purpose. For example, when the substrate is a rectangular board, the length is preferably longer than the long axis or short axis of the board. In this way, the mist can be supplied to a wide area of the board 121, thereby improving productivity.

The temperature adjustment part 105 adjusts the temperature of the base material 101. When the board 121 is heated to form a film, and excessive temperature rise of the coating 102 is expected, the base material 101 can be cooled by the temperature adjustment part 105. In addition, for example, in cases where the gas mixture 111 is preferably heated to some extent before it is discharged, the base material 101 may be heated.

With such a film forming nozzle 1, the temperature of the film-forming nozzle 1 can be adjusted by the temperature adjustment part 105, so damage to the coating 102 due to heat can be prevented. The generation of particles due to evaporation of the raw material mist in the previous stage of film-forming can be reduced, so films with fewer defects can be formed under a wider variety of conditions.

The temperature adjustment part 105 may be a part that adjusts the temperature directly or indirectly, and may be a part that performs heat exchange using a liquid heat medium or gaseous heat medium. It may be a part that uses Peltier effect to cool or a part that heats as an electric heater. A wide variety of known heat media can be used as the heat medium. For example, liquid heat media such as water, glycols, alcohols, and silicone oils, and gaseous heat media such as air, helium, and fluorocarbons are suitably used. However, it is not limited thereto.

The base material 101 preferably contains at least one of a metal, a glass, and a ceramic.

With a film-forming nozzle having such a base material 101, temperature adjustment of the film-forming nozzle 1 becomes easy, making it easier to form high-quality films.

In particular, the base material 101, which includes at least one of a metal, a glass, and a ceramic, can be a material that has sufficient mechanical strength at the processing temperature of a general mist CVD method. In addition, it can be a material with sufficient thermal conductivity to allow temperature control as necessary. The thermal conductivity is preferably 0.5W/(m·K) or more, and more preferably 10.0W/(m·K) or more. More specifically, materials having the above thermal conductivity, such as aluminum alloys, a stainless steel, copper alloys, a soda glass, a borosilicate glass, an aluminoborosilicate glass, a quartz, an alumina, a zirconia, an aluminum nitride, a silicon nitride, and a silicon carbide are suitably used. Aluminum alloys are more suitably used because of their excellent thermal conductivity and processability. By using such a material for the base material 101, it becomes easy to adjust the temperature of the coating 102 by the temperature adjustment part 105, and the film forming can be performed with a constantly stable manner.

Unless otherwise specified, the thermal conductivity here refers to the value at or near room temperature. The thermal conductivity of the base material 101 and the coating 102 described below can be measured by known methods, and can be determined by steady-state methods such as the guarded hot plate method (GHP method) and the heat flow meter method (HFM method), or by non-steady-state methods such as the laser flash method and the hot wire method.

The coating 102 covers the inner surface of the base material 101 and prevents the base material 101 from coming into contact with the gas mixture 111, thereby preventing components of the base material 101 from dissolving into the mist of the gas mixture 111 and contaminating into the film formed on the board 121. For this reason, the coating 102 preferably has higher chemical resistance to the raw material solution (mist) than the base material 101.

More specifically, the coating preferably comprises at least one of a polyethylene, a polypropylene, a vinyl chloride, a polystyrene, a polyvinyl acetate, an urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.

In order to maintain the coating of the base material 101 more stably, the coating 102 should have a thermal expansion coefficient Cc close to a thermal expansion coefficient Cm of the base material 101 at the operating temperature of the film-forming nozzle 1, and therefore Cc/Cm ratio is good to be 0.15 or more and 6 or less, and more preferably 0.5 or more and 2.5 or less. If Cc/Cm ratio is within such range, crack, break, and peeling of the coating can be effectively prevented, so that the coating 102 on the base material 101 can be stably maintained.

For example, when the base material 101 made of aluminum alloy (thermal expansion coefficient of 20 to 24 µm/m·K⁻¹) is used at a temperature at about 100°C or less, polyethylene terephthalate (Cc/Cm=0.84), polyimide (0.63), polyamideimide (1.28), polyolefin (2.09), polyphenylene sulfide (2.05), polysulfone (2.34), polyethersulfone (2.3), polyetheretherketone (2.09), etc. are more suitably used for the coating 102.

If the film-forming nozzle 1 with the inner surface of base metal 101 is covered with such a coating 102, the coating 102 has higher chemical resistance to the raw material solution (mist) than the base material 101, and allows the formation of a high-quality film, in which impurity contamination to the film is more effectively suppressed.

The chemical resistance referred here may be an index that is generally and widely used, and can be evaluated, for example, by immersing a test piece made of the same material as the base material 101 and the coating 102 in the raw material solution or the solution with a higher concentration thereof, and measuring the change in weight, change in volume, discoloration, etc. before and after immersion for a prescribed time by known means.

The coating 102 may be formed by any known method, such as laminating using a thermoplastic material, applying and curing with a UV or thermal curing resins, thermal spraying, sintering with a particulate deposit film, chemical vapor deposition, or physical deposition.

In addition, when water is used as a solvent for the raw material solution, at least a part of the surface of the coating 102 (the surface that comes into contact with the gas mixture 111) is preferably water-repellent.

With such a film-forming nozzle, droplet adhesion to the inner surface of the film-forming nozzle 1 is reduced, suppressing the occurrence of particles generated by precipitation of solids in the droplets and denaturation of the droplets and the compounds that cause defects, making it possible to more stably form high-quality films.

If the surface of the coating 102 is water repellent, it can more effectively prevent the droplet of the gas mixture 111 adhering to the surface of the coating and causing precipitation of the solid matter, and the portion thereof contaminates the gas mixture 111 adhering to the surface of the coating as particles. Alternatively, it can more effectively prevent the droplets adhering to the surface of the coating when heated by the nozzle, from becoming compounds unsuitable for film-forming which then mix with the gas mixture 111 and are contaminated into the film as impurities, thereby degrading the film quality.

The water repellency of the surface of the coating 102 can be obtained by covering the surface of the coating 102 with a highly water repellent material such as a fluorine compound or a silicon compound, or by conducting microfabrication or surface modification treatment that provides water repellency. Water repellency here refers to the surface state where the contact angle of a liquid droplet on a solid surface is 90° or more, and can generally be measured by Contact angle drop method (Ellipse fitting method, Tangent method, Circle method, θ/2 method, Young-Laplace method).

In addition, the coating 102 is preferably made of a material having a lower thermal conductivity than the base material 101.

If the film-forming nozzle 1 has such a base material 101 in which the inner surface of base metal 101 is covered with such a coating 102, the coating 102 does not conduct heat as much as the base material 101, so the temperature of the gas mixture 111 can be maintained. This suppresses the evaporation of the mist and further suppresses the abnormal growth of the film and the precipitation (particle) adhesion to the film caused by the concentration or denaturation of the mist, allowing to more stably produce higher-quality films.

Furthermore, the thermal conductivity of the coating 102 is more preferable to be less than 0.5 W/(m· K).

In addition, the thickness of the coating 102 is preferably 0.01 mm or more and 3 mm or less. If it is 0.01 mm or less, the thermal insulating effect may be significantly reduced, and if it exceeds 3 mm, for example, when the coating 102 is subjected to radiation, it may be overheated and easily damaged. The thickness of the coating 102 can be measured by a known measuring method depending on the material of the base material 101, and can be measured using instruments such as an electromagnetic coating thickness gauge, an eddy current coating thickness gauge, an infrared coating thickness gauge, or an ultrasonic coating thickness gauge. Further preferably, the thickness of the coating 102 is preferably 0.02 mm or more and 3 mm or less.

In order for the coating 102 to maintain its functionality, its shape and properties should be maintained within a prescribed tolerance range. In this case, in addition to the film thickness and roughness of the film surface, changes in surface shape such as waviness and crinkle, as well as cracks, pinholes, discoloration, etc., can be mentioned, all of which can be evaluated by known evaluation methods. The film thickness can be measured suitably using the film thickness measurement methods mentioned above, and changes in surface shape can be measured using contact or non-contact surface shape measurement methods. Cracks and pinholes can be detected by visual inspection or light scattering, or, especially in the case of a film formed on a conductive base material, a method of measuring the electrical resistance between the substrate 101 and the surface of the film 102 can be used.

In this description, "abnormal growth" includes the ones that are observed mainly as cloudiness or discoloration on the appearance of the film, and also the ones that are observed microscopically as textured shapes on the film surface or unevenness such as crystalline grains. In addition, the term "particles" in this description refers to the ones that are observed as particles when observing the surface of the film, including the ones that are incorporated into the film and unified with it, and the ones that adhere to the film surface as foreign matter. The presence or absence of these abnormal growths and particles can be determined and quantitatively measured by known measurement methods using light scattering and microscope images of the film surface.

In order to prevent the gas mixture 111 from coming into contact with the base material 101, the coating 102 is preferably formed so as to cover the surface of the base material 101 that may come into contact with the gas mixture 111. For example, as shown in FIG. 1, when the discharge port 104 is placed so as to face the board 121 almost perpendicularly, the discharged gas mixture 111 flows from the discharge port 104 to the left and right of the page, so the periphery of the discharge port 104 on the outer surface of the base material 101 is preferably covered in addition to the inner surface with a coating. In addition, when the discharge port 104 is placed at an angle to the board 121 as shown in FIG. 2, or when the discharge direction is placed horizontally to the board, a part of the discharged gas mixture 111 may flow between the film-forming nozzle 1 and the board 121. Therefore, in addition to the inner surface of the base material 101, the outer surface facing the board 121 is also preferably covered with a coating. By doing so, not only the chemical reaction between the inner surface of the base material 101 and the gas mixture 111 but also the chemical reaction between the outer surface and the gas mixture 111 is prevented, so that the contamination of impurities into the film (not shown) on the board 121 can be further reduced.

As described above, the film-forming nozzle 1 is preferably covered with the coating 102 on the outer surface of the film-forming nozzle 1 at least which faces the film-forming surface of the substrate (the board 121) on which the film is to be formed. An example in which a plate-shaped board is used as the substrate will be explained below.

With such a film-forming nozzle 1, the coating 102 can prevent contact between the gas mixture 111 and the outer surface of the base material 101 (the surface facing film-forming surface of the substrate (the board 121)) of the film-forming nozzle 1, and prevent the components of the outer surface of the base material 101 from eluting into the raw material mist, allowing to form high-quality films with reduced impurity contamination to the film in a wider variety of film-forming configurations.

The shape of the discharge port 104 is not particularly limited, but it is preferably linear or rectangular in order to make the flow of the gas mixture 111 a more uniform laminar flow. In this case, the length of the discharge port 104 in the longitudinal direction (perpendicular to the page) can be made sufficiently long to match the shape of the substrate (board 121).

Although the film-forming nozzle of the present invention has been explained above using FIGs. 1 and 2, the film-forming nozzle of the present invention is not limited to this, and may also be a film-forming nozzle equipped with an exhaust means as shown in FIG. 3. The film-forming nozzle 3 shown in FIG. 3 is equipped with the base material 301, the coating 302, the supply port 303, the discharge port 304, the intake port 306, the exhaust port 307, and the temperature adjustment part 305, and after the discharged mist is supplied onto a board (not shown), it is discharged through an exhaust means comprising the intake port 306 and the exhaust port 307.

Furthermore, the coating 302 may only cover the area from the supply port 303 to the periphery of the discharge port 304 inside the film-forming nozzle 3, but in addition to this, the gas-contacting part on the exhaust means side is also preferably covered with the coating 302. This not only prevents the base material 301 from corroding inside the exhaust means, but also prevents the products resulting from corrosion from dropping onto and adhering to the board, thereby impairing the film quality. Furthermore, the foreign matter adhesion occurring during such a process can be measured and evaluated in the same way as the particles mentioned above.

The shape of the intake port 306 is not particularly limited, but it is good to be linear or rectangular in order to make the flow of the mixture gas more uniform and laminar. In this case, the length of the intake port 306 in the longitudinal direction (perpendicular to the page) can be made sufficiently long to match the shape of the substrate. In addition, the intake port 306 may be formed so that the direction in which the gas mixture 111 is taken in forms a certain angle with respect to the surface of the substrate, or may be formed horizontally.

### [Film-forming Apparatus]

The present invention also provides a film-forming apparatus capable of producing high-quality films with significantly reduced surface defects and foreign matter adhesion with high productivity.

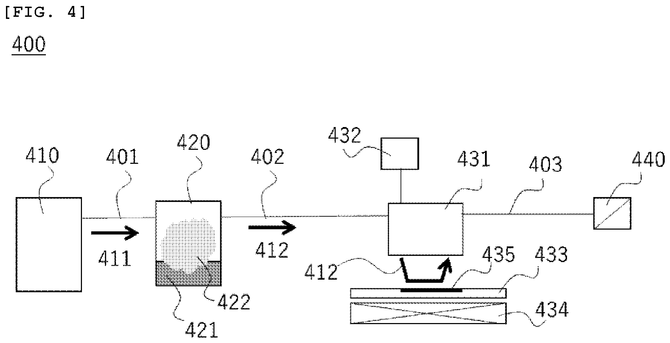

The present invention will be described in detail below with reference to FIG. 4. However, the present invention is not limited thereto.

FIG. 4 shows an example of a film-forming apparatus pertaining to the present invention.

Film-forming apparatus 400 pertaining to the present invention is equipped with the carrier gas supply means 410, the carrier gas piping 401, the atomizing device (atomizing means) 420, the mist piping 402, film-forming nozzle 431, the temperature adjustment part 432, the stage (mounting unit) 433, the heating means 434, the exhaust piping 403, and the exhaust means 440. The board (substrate) 435 on which a film is to be formed is mounted on the stage 433.

A raw material solution (liquid raw material) 421 is stored in the atomizing device 420 as a raw material. The raw material solution 421 is not particularly limited as long as it is a solution that can be atomized (also called "misted"). Organic solvent solutions such as alcohols and ketones containing the raw material, or aqueous solutions containing the raw material according to the purpose can be used.

The raw material solution 421 is atomized by a known means to form raw material mist 422. The carrier gas 411 is further supplied to the atomizing device 420, which is mixed with the raw material mist 422 to form the gas mixture 412, which is then transported through the mist pipe 402 and supplied to the film-forming nozzle 431.

The film-forming nozzle 431 may be the film-forming nozzle described in FIG. 1 to FIG. 3. Here, it will be explained as a nozzle having the form shown in FIG. 3. The gas mixture 412 is supplied to the board 435 from the film-forming nozzle 431. The board 435 is placed so as to face the mist discharge direction of the film-forming nozzle 431, and the gas mixture 412 enters an intake port provided in the film-forming nozzle 431 after being discharged toward the board 435. During this process, the gas mixture 412 reacts with the board 435, forming a film on the board 435.

The surplus of the gas mixture 412 that has not contributed to the film-formation and the by-product generated during the reaction of the gas mixture 412 and the board 435 are collected by the exhaust means 440 and discharged outside the system.

The method for atomizing the raw solution 421 is not particularly limited as long as it can atomize or form droplets of the raw solution 421, and any known method may be used. In the present invention, however, an atomization means using ultrasonic wave is more preferable. Mists or droplets obtained using ultrasonic wave are preferable because they have an initial velocity of zero and float in the air. For example, it is very suitable because, rather than blowing on such as a spray, the mist or droplet floats in space and can be transported as a gas, damage by the collision energy will not occur. The droplet size is not particularly limited and may be about a few mm, but is preferably 50 µm or less, and more preferably 0.1 to 10 µm.

The carrier gas 411 is not particularly limited, and for example, in addition to air, oxygen, and ozone, an inert gas such as nitrogen or argon, or a reducing gas such as hydrogen gas or forming gas is suitably used. The type of the carrier gas 411 may be one type or two or more types. The flow rate of the carrier gas may be set as necessary depending on the size of the board and the size of the film-forming chamber, and may be, for example, about 0.01 to 100 L/min. The gas volume mentioned here refers to the value at standard conditions (0°C, 1 atm).

In addition, although it is not shown, it is possible to further add dilution gas to adjust the ratio of the raw material mist 422 to the carrier gas 411. The flow rate of the dilution gas can be set as necessary, for example, to 0.1 to 10 times per minute of the flow rate of the carrier gas. The dilution gas may be supplied, for example, downstream of the atomizing device 420. The dilution gas to be used may be the same as the carrier gas 411 or may be different.

Although it is not shown, but a second temperature adjustment part may be provided to adjust the temperature of the carrier gas 411 and gas mixture 412. In this case, known heating and cooling means can be used, for example, a line heater or a heat exchanger can be installed on the side of the carrier gas piping 401 and the mist piping 402, or a heat exchanger can be installed on the atomizing device 420 to adjust the temperature of the raw material solution.

Although FIG. 4 shows a configuration in which one atomizing device is used, the present invention is not limited to this, and a plurality of atomizing devices can also be used by connecting them in series or in parallel. In this case, each atomizing device may be used with a different raw material solution or with the same raw material. In addition, each raw material may be atomized separately and supplied to the film-forming nozzle 431 independently, or a plurality of types of raw material mists may be mixed together and then supplied to the film-forming nozzle 431.

The mist piping 402 is not particularly limited as long as it has sufficient stability against the temperature of the raw material solution used or at the interface between the film-forming nozzle unit and the transport piping, and can be manufactured of a resin, a metal, a glass, or a combination of these materials depending on the purpose.

The structure of the stage 433 is not particularly limited as long as it can hold the board 435 during film-forming, and as long as it has sufficient stability according to the characteristics of the raw material used and the temperature conditions. In this case, metals such as aluminum and stainless steel may be used, but when film-forming is performed at a higher temperature than the heat-resistance temperature of these metals or when an acidic or alkaline raw material is used, alloys such as Hastelloy, soda-lime glass, borosilicate glass, quartz, silicon carbide, or ceramics such as silicon nitride and aluminum nitride may also be used.

The heating means 434 may heat the board 435 directly or indirectly, and may be a known heating means such as a resistance heater or a lamp heater. When a heater is used, for example, it may be built into the stage 433 or installed outside the stage 433.

In addition, the stage 433 may be equipped with a mechanism for holding the board 435. In this case, known board holding methods such as a vacuum chuck, a mechanical chuck, or an electrostatic chuck can be used.

The board (substrate) 435 is not particularly limited as long as it can support the film to be formed. The material of the board (substrate) 435 is not particularly limited, and may be a known material, and may be an organic compound or an inorganic compound. Examples of such materials include, but are not limited to, polysulfone, polyethersulfone, polyphenylene sulfide, polyetheretherketone, polyimide, polyetherimide, fluororesin, metals such as iron, aluminum, stainless steel, and gold, silicon, sapphire, quartz, glass, calcium carbonate, lithium tantalate, lithium niobate, gallium oxide, SiC, ZnO, and GaN. As for the form of a board (substrate), it is not limited in this invention. However, the board with the area of 5cm² or more is preferable, 10cm² or more is more preferable, and the thickness of 50 to 2000 µm is preferable, and 100 to 800 µm is more preferable.

In addition, the film-forming apparatus of the present invention may be the one in which the board (substrate) 435 and the film-forming nozzle 431 are facing each other and are held still at a prescribed position while film-forming is performed, or more preferably, may be equipped with a transporting means (not shown) that can change the relative position in the horizontal direction. By being equipped with a transporting means, it is possible to achieve better thickness distribution of the film to be formed, and it becomes easier to form a film on a long board. In this case, the film-forming nozzle 431 may be transported, or the stage 433 may be transported, but transporting the stage 433 is preferable. The transporting may be a horizontal reciprocating movement in one axial direction, or a horizontal rotational movement. The transporting speed in the case of transporting to one axial direction may be adjusted as necessary according to the purpose, but set it to 0.1 mm/s to 100 mm/s is preferable, and 1 mm/s or more to 30 mm/s is more preferable. If the speed is less than 1 mm/s, the film formation often becomes the reaction rate limiting factor, resulting in a decrease in the yield of raw materials. If it exceeds 100mm/s, the gas mixture 412 will not be able to follow the transporting motion, and the film thickness distribution will deteriorate.

The film-forming may be conducted under any of the atmospheric pressure, the increasing pressure, and the decreasing pressure conditions, but from the viewpoints of equipment cost and productivity, conducting under atmospheric pressure is preferable.

In the configuration shown in FIG. 4, the film-forming nozzle 431 is placed above the stage 433, and a film is formed with the film-forming surface of the board 435 facing upward. However, the film-forming apparatus pertaining to the present invention is not limited to this, and adopting a configuration in which the film-forming nozzle 431 is placed below the stage 433 is also possible, and a film can be formed with the film-forming surface of the board 435 facing downward.

As described above, the film-forming apparatus 400 pertaining to the present invention comprises the atomization means 420 for the atomizing liquid raw material 421 to generate the raw material mist 422, the carrier gas 411 for transporting the raw material mist 422, the film-forming nozzle 431 for supplying the gas mixture 412 of the material mist 422 and the carrier gas 411 to the surface of a substrate (board 435), the exhaust means 440 for exhausting the gas mixture 412, the mounting part (stage 433) for mounting the substrate 435, and the heating means 434 for heating the substrate 435, and wherein,
the film-forming nozzle 431 comprises a supply port into which the gas mixture 412 flows, and a discharge port spatially connected to the supply port and from which the gas mixture flows out; and
the inner surface of a flow path of the gas mixture from the supply port to the discharge port of the film-forming nozzle 431 is covered with a coating made of a material different from a base material forming a basic structure of the film-forming nozzle 431.

With such a film-forming apparatus 400, the contact between the gas mixture 412 and the inner surface of the base material of the film-forming nozzle 431 can be avoided by the coating, and the components of the base material can be prevented from eluting into the raw material mist 422, so that the contamination of impurities in the film formed on the surface of the substrate 435 can be suppressed, and a high-quality film can be formed.

In addition, since the film-forming nozzle mentioned above in [Film-forming Nozzle] can be used in the film-forming apparatus of the present invention, a film-forming apparatus having the same effect can be provided.

### EXAMPLES

### (Example 1)

The present invention will be explained below in detail with reference to Examples. However, the present invention is not limited thereto.

### [Apparatus]

In the film-forming apparatus shown in FIG. 4, the film-forming nozzle shown in FIG. 3 was applied and film-formation of an α-gallium oxide was conducted.

An aluminum alloy (A5052, thermal conductivity 140 W/(m·K)) was used as the base material for the film-forming nozzle, and a coating of polytetrafluoroethylene (PTFE) (thermal conductivity 0.23 W/(m·K), contact angle 106°) with a coating thickness of 0.05 mm was formed on the inner surface of the film-forming nozzle.

A gas cylinder filled with nitrogen gas was used to supply the carrier gas. The gas cylinder and the atomizing device were connected with a urethane resin tube, and the atomizing device and the film-forming nozzle were further connected with a PTFE piping.

Next, the film-forming nozzle was connected to a circulator, and water was circulated inside the film-forming nozzle to maintain the surface temperature of the film-forming nozzle at 50°C.

Next, a c-plane sapphire board with a thickness of 0.6 mm and a diameter of 4 inches (approximately 10 cm) was placed on the stage and heated to a board temperature of 400°C.

### [Raw Material Preparation]

As a raw material solution, gallium chloride was dissolved in pure water at a percentage of 0.15 mol/L, which was then stirred for 10 minutes with a stirrer and filled into the atomizing device. The atomizing device used was equipped with two ultrasonic vibration plates (frequency 2.4 MHz).

Next, ultrasonic vibration was transmitted through the water using an ultrasonic vibration plate to the precursor inside the atomizing device, and the raw material solution was atomized (turned into mist).

### [Film-forming]

Next, nitrogen gas was added to the raw material container at a flow rate of 20 L/min, and a gas mixture of the mist and nitrogen gas was supplied to the film-forming nozzle. The exhaustion was performed at an exhaust flow rate of 20 L/min. In addition, during this time, the stage was transported horizontally so that the discharge port of the mist of the film-forming nozzle passes uniformly over the board, and film-forming was continued for 60 minutes.

Immediately after this, the supply of nitrogen gas was stopped, and the supply of the gas mixture to the film-forming nozzle unit was also stopped.

The crystal layer of the laminate produced showed a peak at 2 θ = 40.3° using an X-ray diffraction measuring device (Rigaku SmartLab), which confirmed that it is an α phase of the Ga₂O₃.

After this, in addition, the density of foreign matter (diameter 0.5 µm or more) on the film was evaluated using a wafer inspection system (KLA candela-CS10). Furthermore, using secondary ion mass spectrometry (CAMECA IMS-6f), aluminum concentration in the film (minimum limit of detection 1×10¹⁵cm⁻³) was evaluated.

### (Example 2)

The film was formed in the same manner as in Example 1, except that the coating was formed on the inner surface of the film-forming nozzle with a polyethylene (thermal conductivity 0.34 W/(m·K), contact angle 99°) with a coating thickness of 0.05 mm thickness of 0.074 mm.

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Example 3)

The film was formed in the same manner as in Example 1, except that the coating was formed on the inner surface of the film-forming nozzle with a polyvinylidene chloride (thermal conductivity 0.13 W/(m· K)) with a coating thickness of 0.06 mm.

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Example 4)

The film was formed in the same manner as in Example 1, except that a polyethylene coating with a coating thickness of 0.074 mm was formed on the inner surface of the film-forming nozzle, and the surface was made hydrophilic (contact angle 64°) by irradiating it with UV light with a wavelength of 172 nm (QEV-230 manufactured by Quark Technology).

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Comparative Example 1)

The film was formed in the same manner as in Example 1, except that no coating was formed on the inner surface of the film-forming nozzle (base material surface, contact angle 12°).

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Example 5)

The film was formed in the same manner as in Example 1, except that a PTFE coating with a coating thickness of 0.050 mm was formed on the inner surface of the film-forming nozzle and further the temperature of the film-forming nozzle was set to 80°C.

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Example 6)

The film was formed in the same manner as in Example 1, except that a PTFE coating with a coating thickness of 2.5 mm was formed on the inner surface of the film-forming nozzle and further the temperature of the film-forming nozzle was set to 80°C.

The crystal layer of the laminate produced showed a peak at 2θ = 40.3° using an X-ray diffraction measuring device, which confirmed that it is an α phase of the Ga₂O₃.

After this, the film was evaluated in the same manner as in Example 1.

### (Comparative Example 2)

The film was formed in the same manner as in Example 1, except that no coating was formed on the inner surface of the film-forming nozzle and further the temperature of the film-forming nozzle was set to 80°C.

The crystal layer of the laminate produced showed a peak at 2θ = 39.0° in addition to 2θ = 40.3° using an X-ray diffraction measuring device, which confirmed that it is a mixture of an α phase and ε phase of the Ga₂O₃.

After this, the film was evaluated in the same manner as in Example 1.

### (Example 7)

A film-forming nozzle of the same shape as that of Example 1 was prepared using borosilicate glass (thermal conductivity 1.2 W/(m·K)) as the base material, and a PTFE coating with a coating thickness of 2.5 mm was formed on the inner surface. Using this film-forming nozzle, the film-forming nozzle temperature was set to 80°C. Other than these, film-forming was conducted in the same manner as in Example 1.

The crystal layer of the laminate produced showed a peak at 2θ = 40.3° using an X-ray diffraction measuring device, which confirmed that it is an α phase of the Ga₂O₃.

After this, the density of foreign matter (diameter 0.5 µm or more) on the film was evaluated using a wafer inspection system (KLA candela-CS10) in the same manner as in Example 1. Furthermore, silicon concentration (minimum limit of detection 1×10¹⁷cm⁻³) in the film was evaluated using secondary ion mass spectrometry (CAMECA IMS-6f).

### (Comparative Example 3)

The film was formed in the same manner as in Comparative Example 1, except that the base material of the film-forming nozzle was made of borosilicate glass and further the temperature of the film-forming nozzle was set to 80°C.

The crystal layer of the laminate produced showed a peak at 2θ = 40.3° using an X-ray diffraction measuring device, which confirmed that it is an α phase of the Ga₂O₃.

After this, the film was evaluated in the same manner as in Example 7.

**[Table 1]**

| | Al concentration in the film [atoms/cm³] | Si concentration in the film [atoms/cm³] | Particle density [pieces/cm²] |
|---|---|---|---|
| Example 1 | Minimum limit of detection | - | 0.2 |
| Example 2 | Minimum limit of detection | - | 0.4 |
| Example 3 | Minimum limit of detection | - | 2.4 |
| Example 4 | Minimum limit of detection | - | 2.5 |
| Comparative Example 1 | 9.2×10¹⁶ | - | 185.5 |
| Example 5 | Minimum limit of detection | - | 3.4 |
| Example 6 | Minimum limit of detection | - | 0.3 |
| Comparative Example 2 | 1.5×10¹⁷ | | 402.3 |
| Example 7 | | Minimum limit of detection | 0.2 |
| Comparative Example 3 | | 2.5×10¹⁷ | 3.1 |

Table 1 shows, firstly, the evaluation results of Examples 1 to 4 and Comparative Example 1. In all cases, the base material of the film-forming nozzle is an aluminum alloy, and when comparing Examples 1 to 4, which have a coating on the inside surface, with Comparative Example 1, which has no coating on the inside surface, it was shown that the impurity concentration derived from the base material (Al concentration in the film) and the foreign matter density (particle density) were significantly reduced.

Secondly, the evaluation results of Examples 5 and 6 and Comparative Example 2 are shown. In all cases, the base material of the film-forming nozzle is an aluminum alloy, and the film-forming nozzle temperature was set at 80°C. When comparing Examples 5 and 6, which have a coating on the inner surface, with Comparative Example 2, which has no coating on the inner surface, it was shown that the impurity concentration derived from the base material (Al concentration in the film) and foreign matter density (particle density) were significantly reduced.

Thirdly, the evaluation results of Example 7 and Comparative Example 3 are shown. In all cases, the base material of the film-forming nozzle is a borosilicate glass, and the film-forming nozzle temperature was 80°C. When comparing Example 7, which has a coating on the inner surface, with Comparative Example 3, which has no coating on the inner surface, it was shown that the impurity concentration (Si concentration in the film) and foreign matter density (particle density) derived from the base material were significantly reduced.

In all cases in the Examples, the film formed was an α-Ga₂O₃. This demonstrates that high-quality films can be stably manufactured.

From the results, it was found that the present invention can provide a film-forming apparatus capable of stably producing higher quality films than conventional techniques.

In addition, it should be noted that the present invention is not limited to the embodiments. The embodiments are just examples, and any examples that have substantially the same features and demonstrate the same functions and effects as those in the technical concept disclosed in claims of the present invention are included in the technical scope of the present invention.

The present description includes the following embodiments.
[1]: A film-forming nozzle, wherein:
   the film-forming nozzle supplies a gas mixture to a substrate surface, the gas mixture comprising a carrier gas and a raw material mist obtained by atomizing a liquid raw material; and
   comprises a supply port into which the gas mixture flows, and a discharge port spatially connected to the supply port and from which the gas mixture flows out; and
   an inner surface of a flow path of the gas mixture from the supply port to the discharge port of the film-forming nozzle is covered with a coating made of a material different from a base material forming a basic structure of the film-forming nozzle.
[2]: The film-forming nozzle according to the above [1], wherein the film-forming nozzle comprises a temperature adjustment part for adjusting a temperature of the film-forming nozzle.
[3]: The film-forming nozzle according to the above [1] or [2], wherein the film-forming nozzle is covered with the coating on an outer surface of the film-forming nozzle, the outer surface being at least a surface that faces a film-forming surface of a substrate on which a film is to be formed.
[4]: The film-forming nozzle according to any of the above [1] to [3], wherein the coating comprises at least one of a polyethylene, a polypropylene, a vinyl chloride, a polystyrene, a polyvinyl acetate, an urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.
[5]: The film-forming nozzle according to any of the above [1] to [4], wherein at least a part of a surface of the coating is water-repellent.
[6]: The film-forming nozzle according to any of the above [1] to [5], wherein a thermal conductivity of the coating is lower than a thermal conductivity of the base material.
[7]: The film-forming nozzle according to any of the above [1] to [6], wherein the base material contains at least one of a metal, a glass, and a ceramic.
[8]: A film-forming apparatus, wherein the film-forming apparatus comprises:
   an atomization means for atomizing a liquid raw material to generate a raw material mist;
   a carrier gas for transporting the raw material mist;
   a film-forming nozzle for supplying a gas mixture to a substrate surface, the gas mixture being a mixture of the raw material mist and the carrier gas;
   an exhaust means for exhausting the gas mixture;
   a mounting part for mounting the substrate;
   a heating means for heating the substrate; and wherein:
      the film-forming nozzle comprises a supply port into which the gas mixture flows, and a discharge port spatially connected to the supply port and from which the gas mixture flows out; and
      an inner surface of a flow path of the gas mixture from the supply port to the discharge port of the film-forming nozzle is covered with a coating made of a material different from a base material forming a basic structure of the film-forming nozzle.
[9]: The film-forming apparatus according to the above [8], wherein the film-forming nozzle comprises a temperature adjustment part for adjusting a temperature of the film-forming nozzle.
[10]: The film-forming apparatus according to the above [8] or [9], wherein the film-forming nozzle is covered with the coating on an outer surface of the film-forming nozzle, the outer surface being at least a surface that faces a film-forming surface of a substrate on which a film is to be formed.
[11]: The film-forming apparatus according to any of the above [8] to [10], wherein the coating comprises at least one of a polyethylene, a polypropylene, a vinyl chloride, a polystyrene, a polyvinyl acetate, a urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.
[12]: The film-forming apparatus according to any of the above [8] to [11], wherein at least a part of a surface of the coating is water-repellent.
[13]: The film-forming apparatus according to any of the above [8] to [12], wherein a thermal conductivity of the coating is lower than a thermal conductivity of the base material.
[14]: The film-forming apparatus according to any of the above [8] to [13], wherein the base material contains at least one of a metal, a glass, and a ceramic.

In addition, it should be noted that the present invention is not limited to the embodiments. The embodiments are just examples, and any examples that have substantially the same features and demonstrate the same functions and effects as those in the technical concept disclosed in claims of the present invention are included in the technical scope of the present invention.

## Claims

1. A film-forming nozzle, wherein:
the film-forming nozzle supplies a gas mixture to a substrate surface, the gas mixture comprising a carrier gas and a raw material mist obtained by atomizing a liquid raw material; and
comprises a supply port into which the gas mixture flows, and a discharge port spatially connected to the supply port and from which the gas mixture flows out; and
an inner surface of a flow path of the gas mixture from the supply port to the discharge port of the film-forming nozzle is covered with a coating made of a material different from a base material forming a basic structure of the film-forming nozzle.

2. The film-forming nozzle according to claim 1, wherein the film-forming nozzle comprises a temperature adjustment part for adjusting a temperature of the film-forming nozzle.

3. The film-forming nozzle according to claim 1, wherein the film-forming nozzle is covered with the coating on an outer surface of the film-forming nozzle, the outer surface being at least a surface that faces a film-forming surface of a substrate on which a film is to be formed.

4. The film-forming nozzle according to claim 1, wherein the coating comprises at least one of a polyethylene, a polypropylene, a vinyl chloride, a polystyrene, a polyvinyl acetate, an urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.

5. The film-forming nozzle according to claim 1, wherein at least a part of a surface of the coating is water-repellent.

6. The film-forming nozzle according to claim 1, wherein a thermal conductivity of the coating is lower than a thermal conductivity of the base material.

7. The film-forming nozzle according to any one of claims 1 to 6, wherein the base material contains at least one of a metal, a glass, and a ceramic.

8. A film-forming apparatus, wherein the film-forming apparatus comprises:
an atomization means for atomizing a liquid raw material to generate a raw material mist;
a carrier gas for transporting the raw material mist;
a film-forming nozzle for supplying a gas mixture to a substrate surface, the gas mixture being a mixture of the raw material mist and the carrier gas;
an exhaust means for exhausting the gas mixture;
a mounting part for mounting the substrate;
a heating means for heating the substrate; and wherein:
the film-forming nozzle comprises a supply port into which the gas mixture flows, and a discharge port spatially connected to the supply port and from which the gas mixture flows out; and
an inner surface of a flow path of the gas mixture from the supply port to the discharge port of the film-forming nozzle is covered with a coating made of a material different from a base material forming a basic structure of the film-forming nozzle.

9. The film-forming apparatus according to claim 8, wherein the film-forming nozzle comprises a temperature adjustment part for adjusting a temperature of the film-forming nozzle.

10. The film-forming apparatus according to claim 8, wherein the film-forming nozzle is covered with the coating on an outer surface of the film-forming nozzle, the outer surface being at least a surface that faces a film-forming surface of a substrate on which a film is to be formed.

11. The film-forming apparatus according to claim 8, wherein the coating comprises at least one of a polyethylene, a polypropylene, a vinyl chloride, a polystyrene, a polyvinyl acetate, a urethane resin, a fluororesin, an acrylonitrile butadiene styrene resin, an acrylic resin, a polyamide, a polyimide, a polyamideimide, a nylon, an acetal resin, a polycarbonate, a polyphenylene ether, a polyester, a polyethylene terephthalate, a polybutylene terephthalate, a polyolefin, a polyphenylene sulfide, a polysulfone, a polyethersulfone, a polyarylate, a polyetheretherketone, an acrylic rubber, an isoprene rubber, a urethane rubber, an ethylene propylene rubber, an ethylene vinyl acetate rubber, a chloroprene rubber, a styrene rubber, a nitrile rubber, a fluororubber, a butadiene rubber, a butyl rubber, an aluminum oxide, an aluminum nitride, a silicon oxide, a silicon nitride, and a silicon carbide.

12. The film-forming apparatus according to claim 8, wherein at least a part of a surface of the coating is water-repellent.

13. The film-forming apparatus according to claim 8, wherein a thermal conductivity of the coating is lower than a thermal conductivity of the base material.

14. The film-forming apparatus according to any one of claims 8 to 13, wherein the base material contains at least one of a metal, a glass, and a ceramic.
